(19) **Europäisches Patentamt**

**European Patent Office**

**Office européen des brevets**

(11) Numéro de publication : **0 615 344 A1**

(12) # DEMANDE DE BREVET EUROPEEN

(21) Numéro de dépôt : **94400522.2**

(22) Date de dépôt : **10.03.94**

(51) Int. Cl.⁵ : **H03M 3/02**

(30) Priorité : **11.03.93 FR 9302797**

(43) Date de publication de la demande :
**14.09.94 Bulletin 94/37**

(84) Etats contractants désignés :
**DE GB**

(71) Demandeur : **FRANCE TELECOM**
**6, Place d'Alleray**
**F-75015 Paris (FR)**

(72) Inventeur : **Senn, Patrice**
**13, Grande Rue**
**F-38000 Grenoble (FR)**
Inventeur : **Balestro, Freddy**
**18, boulevard Foch**
**F-38000 Grenoble (FR)**

(74) Mandataire : **Casalonga, Axel**
**BUREAU D.A. CASALONGA - JOSSE**
**Morassistrasse 8**
**D-80469 München (DE)**

(54) **Codeur perfectionné à mise en forme du spectre de bruit, en particulier de type deltasigma.**

(57) Le codeur comprend, en tête, un amplificateur à gain ajustable par capacités commutées (A0, C1, C2, C4). Une partie des éléments de l'amplificateur à gain ajustable forme également l'intégrateur à capacité commutée du codeur (AO, C1, C2).

FIG.4

EP 0 615 344 A1

L'invention concerne la conversion de signal et notamment la conversion delta-sigma. Les codeurs de ce type sont utilisés classiquement pour la conversion analogique/numérique ou numérique/analogique.

Lorsqu'un tel codeur ou convertisseur reçoit comme signal d'entrée un signal analogique, les variations de tension de ce dernier peuvent s'avérer incompatibles avec les excursions autorisées pour le convertisseur, notamment au niveau de son intégrateur. Les codeurs delta-sigma classiques sont alors précédés d'un préamplificateur à gain variable afin d'adapter les variations du signal d'entrée dans une plage de tensions acceptables par le codeur. Or, l'adjonction d'un tel préamplificateur, en amont de l'entrée du codeur delta-sigma, introduit une consommation supplémentaire de courant et prend de la place sur la pastille de silicium sur laquelle sont implantés les différents composants.

L'invention vise à apporter une solution à ce problème.

Un but de l'invention est de permettre l'adaptation des variations du signal d'entrée aux excursions autorisées pour le codeur delta-sigma d'une manière très simple en économisant de la consommation et de la place.

L'invention propose donc un codeur à mise en forme du spectre de bruit, en particulier de type delta-sigma, comportant, en tête, un amplificateur à gain ajustable par capacités commutées.

En d'autres termes, l'invention consiste à intégrer, au sein du codeur lui-même, c'est-à-dire en aval de son entrée, la fonction de gain ajustable.

D'une façon particulièrement avantageuse, une partie au moins des éléments de l'amplificateur à gain ajustable forme également l'intégrateur à capacité commutée du codeur.

Selon un mode de réalisation de l'invention, le codeur comprend un amplificateur opérationnel entre la sortie et l'une des entrées duquel est connectée une capacité de contre-réaction, ainsi qu'une charge capacitive commutée, reliée à ladite entrée de l'amplificateur opérationnel, et ajustable pour prendre des valeurs capacitives différentes.

Cette charge capacitive comporte de préférence au moins une capacité commandable pour prendre un état passif et un état actif vis-à-vis de l'amplificateur opérationnel.

Par ailleurs, il est généralement préférable de travailler en entrée de l'intégrateur avec un signal différentiel afin de diminuer notamment le bruit généré par les alimentations et les harmoniques d'ordre pair. Or, on ne dispose souvent en entrée du codeur delta-sigma que d'un signal d'entrée unique. Un autre but de l'invention consiste alors à élaborer de façon simple un signal différentiel attaquant l'intégrateur du codeur delta-sigma à partir d'un signal d'entrée unique. On prévoit pour cela un étage d'entrée à capacités commutées par deux horloges non recouvrantes, dont les deux sorties sont reliées à l'intégrateur du codeur.

Selon un mode de réalisation de l'invention, l'étage d'entrée comporte une première capacité susceptible d'être connectée entre l'entrée et la masse par un premier moyen de commutation commandable par la première horloge, et entre la masse et l'une des sorties par un deuxième moyen de commutation commandable par la deuxième horloge, ainsi qu'une deuxième capacité susceptible d'être connectée entre l'entrée et l'autre sortie par un troisième moyen de commutation commandable par la deuxième horloge.

Les première et deuxième capacités sont avantageusement respectivement constituées de deux charges capacitives à valeurs ajustables; On réalise alors avec les mêmes éléments, à la fois la fonction de gain ajustable et celle de production d'un signal d'entrée différentiel pour l'intégrateur.

D'autres avantages et caractéristiques de l'invention apparaîtront à l'examen d'un exemple de réalisation nullement limitatif de l'invention illustré sur les dessins annexés sur lesquels :

- les figures 1 et 2 illustrent de façon schématique la structure générale d'un codeur à mise en forme du spectre de bruit, en particulier de type delta-sigma,
- la figure 3 illustre schématiquement un montage à capacité commutée par deux horloges non recouvrantes,
- la figure 4 illustre schématiquement un premier mode de réalisation d'un codeur selon l'invention, et
- la figure 5 illustre un autre mode de réalisation d'un codeur selon l'invention.

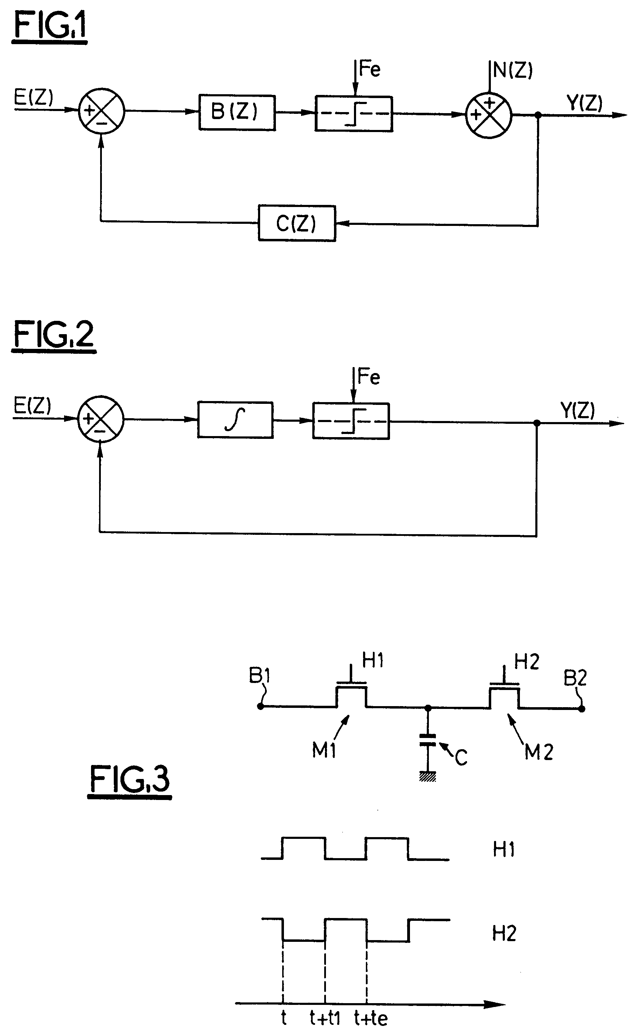

La structure générale des codeurs à mise en forme du spectre de bruit, et notamment de type delta-sigma, a fait l'objet de nombreuses publications, en particulier le brevet français n° 82 15857 dont le contenu est à toutes fins utiles incorporé à la présente description. On va rappeler ici succinctement la structure de tels codeurs, en se référant plus particulièrement aux figures 1 et 2.

Le codeur représenté schématiquement sur la figure 1 reçoit un signal E(Z) échantillonné, auquel on soustrait un signal de sortie d'un filtre de contre-réaction C(Z). Le signal résultant, après passage dans un filtre B(Z) attaque un quantifieur commandé par la fréquence d'échantillonnage Fe du signal E(Z). La référence N(Z) représente le bruit propre à tout convertisseur qui s'ajoute au signal de sortie du quantifieur. Le signal de sortie Y(Z) du codeur s'exprime classiquement par l'équation suivante:

$$Y(Z) = B(Z) . (E(Z) - Y(Z) . C(Z)) + N(Z)$$

dans laquelle B(Z) et C(Z) représentent en fait les fonctions de transfert des filtres correspondants.

Cette équation peut également s'écrire sous la forme :

$$Y(Z) = E(Z) \cdot B(Z)/(1 + B(Z) \cdot C(Z)) + N(Z)/(1 + B(Z) \cdot C(Z)).$$

On dit alors que l'on a un codeur à mise en forme du spectre de bruit quand B(Z) et C(Z) vérifient les équations suivantes :

$$B(Z)/(1 + B(Z) \cdot C(Z)) = Z^{-P}$$
$$1 + B(Z) \cdot C(Z) = H(Z)$$

Concrètement, le but d'un codeur à mise en forme du spectre de bruit est de repousser une partie de la puissance du bruit à l'extérieur de la bande passante du signal d'entrée, c'est-à-dire de procéder à une mise en forme du spectre de bruit. Lorsque la fonction B(Z) est de la forme:

$$1/(1-Z^{-1})^n,$$

le codeur à mise en forme du spectre de bruit est alors un codeur de type delta-sigma, dont l'ordre est donné par la puissance n de la fonction B(Z).

Un codeur delta-sigma d'ordre 1 est illustré sur la figure 2. L'additionneur d'entrée reçoit d'une part le signal E(Z) déjà échantillonné ainsi que le signal de sortie Y(Z). Le signal résultant attaque un intégrateur suivi d'un quantifieur recevant sur son entrée de commande le signal d'échantillonnage à la fréquence Fe.

Il s'avère généralement intéressant de réaliser des codeurs (en particulier de type delta-sigma) utilisant des montages à capacités commutées ce qui rend ces codeurs peu sensibles au bruit et permet par ailleurs d'obtenir des précisions sur les constantes de temps des intégrateurs, en général meilleures que 1%. La figure 3 rappelle la technique des capacités commutées par deux horloges non recouvrantes H1 et H2.

Le principe est de substituer à une résistance qui serait connectée entre deux bornes B1 et B2, une capacité C dont une borne est reliée à la masse et dont l'autre est reliée respectivement aux deux bornes B1 et B2 par deux commutateurs M1 et M2, tels que des transistors à effet de champ à grille isolée commandés sur leur grille par des signaux cadencés par les horloges H1 et H2. Ainsi, à l'instant t, M1 est par exemple passant et la capacité C est alors chargée par la tension V1 présente à la borne B1. A l'instant t+t1 le transistor M1 est bloqué et le transistor M2 est passant ce qui charge la capacité C par la tension V2 présente à la borne B2. Si "te" désigne la période d'échantillonnage, le courant équivalent passant de la borne B1 à la borne B2 pendant cette période est égal à C.(V1-V2)/te. On définit ainsi en capacité commutée une résistance équivalente égale à 1/Fe.C.

On a représenté ici à des fins de simplification des horloges H1 et H2 exactement complémentaires c'est-à-dire avec les fronts montants de l'une correspondant aux fronts descendants de l'autre. Néanmoins, il est possible de prévoir des horloges non recouvrantes définissant un temps mort pendant lequel aucun des deux commutateurs n'est passant (ou fermé).

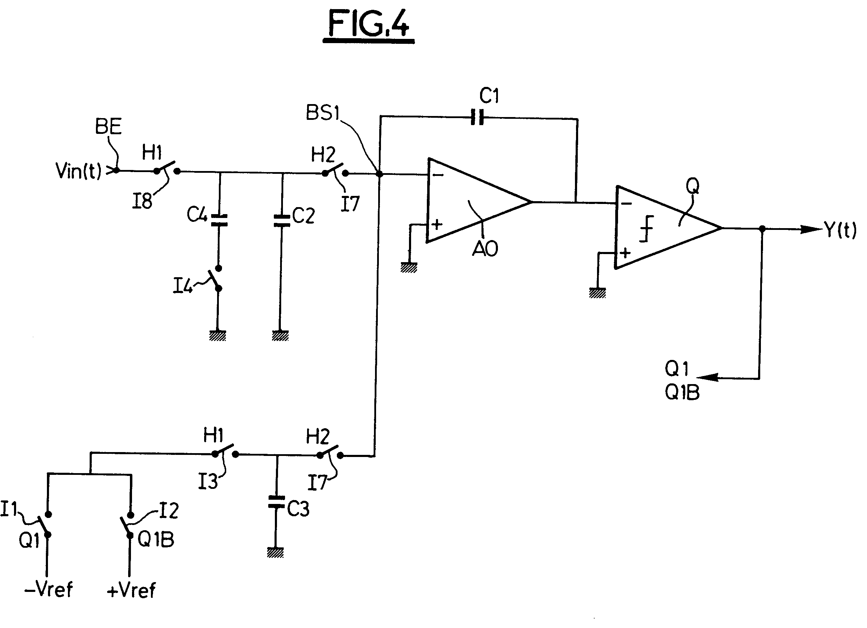

Le codeur delta-sigma d'ordre 1, représenté sur la figure 4, comporte un amplificateur opérationnel AO dont la sortie est reliée à l'entrée inverseuse par une capacité C1 de contre-réaction et dont l'entrée non inverseuse est reliée à la masse. La sortie de cet amplificateur opérationnel AO est reliée à l'entrée d'un quantifieur Q dont la sortie matérialise celle du codeur delta-sigma. Le signal de sortie Q1 du quantifieur Q et son complément Q1B, sont utilisés pour commander deux commutateurs I1 et I2, tels que des transistors à effet de champ, permettant d'appliquer des tensions -Vref et +Vref à une capacité C3 commutée par deux commutateurs I3 et I7 commandés respectivement par les horloges H1 et H2. Cette capacité commutée C3 est reliée à l'entrée inverseuse de l'amplificateur opérationnel AO et va permettre d'ajouter au signal d'entrée les tensions ±Vref.

L'étage d'entrée de ce codeur delta-sigma reçoit en sa borne d'entrée BE un signal d'entrée analogique Vin(t) qui, au niveau du noeud BS1 relié à l'entrée inverseuse de l'amplificateur opérationnel AO, aura été échantillonné par l'intermédiaire de deux commutateurs I8 et I7 d'une charge capacitive commutée, formée ici de deux capacités C2 et C4 montées en parallèle. L'une de ces capacités, par exemple la capacité C4, est susceptible d'être reliée à la masse par l'intermédiaire d'un commutateur I4 commandé par un signal de commande non représenté à des fins de simplification. Ce commutateur I4 peut être par exemple un transistor à effet de champ à grille isolée susceptible de prendre un état passant ou bloqué en fonction de la tension appliquée sur sa grille. On peut remarquer d'ores et déjà que lorsque le commutateur I4 est ouvert (transistor dans son état bloqué) la capacité C4 est inactive vis-à-vis de l'amplificateur opérationnel AO alors qu'elle est active lorsque le commutateur I4 est dans son état fermé (transistor dans son état passant).

On va maintenant décrire le fonctionnement de ce codeur en supposant que le commutateur I4 est ouvert, rendant la capacité C4 inactive. Lorsque les commutateurs I3 et I8 sont fermés, les capacités C2 et C3 se chargent. Lorsque les commutateurs I3 et I8 sont ouverts et que les commutateurs I7 sont fermés, la somme des charges des capacités C2 et C3 est injectée à l'entrée inverseuse de l'amplificateur opérationnel AO. Par ailleurs, le gain de cet étage d'entrée est proportionnel au rapport C1/C2. L'homme du métier remarque donc que l'intégrateur-sommateur de ce codeur delta-sigma se compose ici de l'amplificateur opérationnel AO et des capacités C1, C2 et C3. Par ailleurs, l'amplificateur AO et les capacités C1 et C2 forment un amplificateur à gain proportionnel au rapport C1/C2.

Lorsque l'amplitude de la tension d'entrée Vin est susceptible de prendre des valeurs différentes, il se peut que la somme de cette tension d'entrée et de la tension de référence Vref ne soit pas compatible avec la plage de fonctionnement de l'amplificateur opérationnel AO. Aussi, dans ce cas, on ajuste de façon très simple le gain de l'amplificateur en agissant sur la valeur capacitive de la charge capacitive de l'étage d'entrée, par exemple en rendant active par fermeture du commutateur I4, la capacité C4. Le gain de l'étage d'entrée est alors proportionnel au rapport C1/(C2+C4). Bien entendu, on pourrait concevoir une charge capacitive commutée composée de plusieurs capacités commandables individuellement et montées en parallèle ce qui permettrait alors de sélectionner le gain de l'amplificateur parmi un jeu de valeurs prédéterminées.

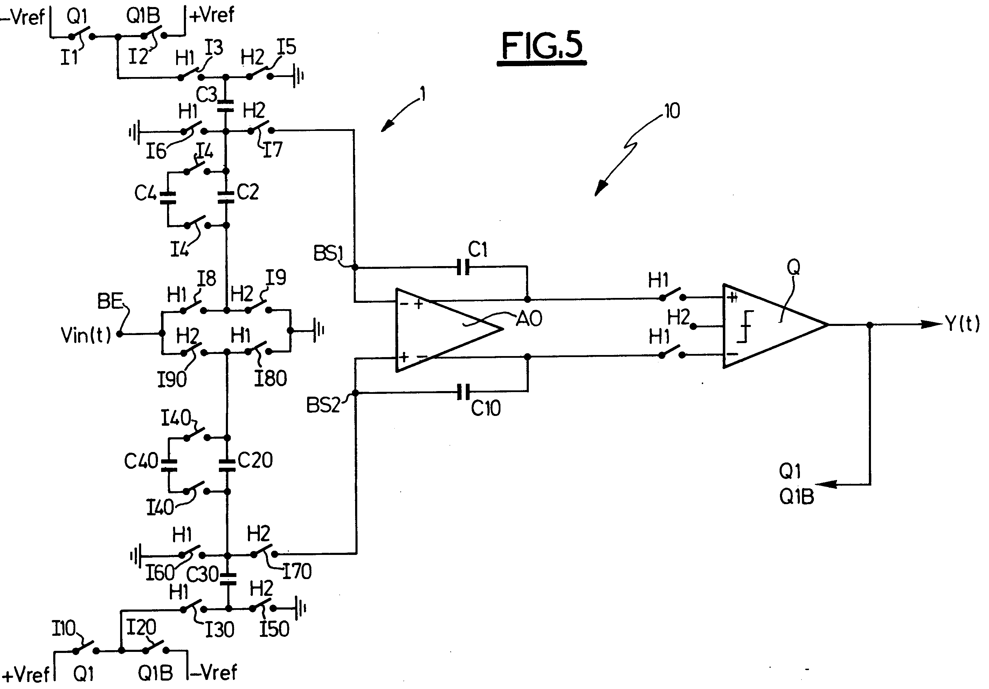

Sur la figure 5, l'étage d'entrée 1 du codeur 10 comporte une borne d'entrée BE pour le signal d'entrée Vin(t) et deux bornes de sortie BS1 et BS2 pour un signal différentiel. Cet étage d'entrée comporte, d'une façon générale, une première capacité susceptible d'être connectée entre l'entrée et la masse par un premier moyen de commutation commandable par la première horloge H1, et entre la masse et l'une des sorties par un deuxième moyen de commutation commandable par la deuxième horloge H2, ainsi qu'une deuxième capacité susceptible d'être connectée entre l'entrée et l'autre sortie par un troisième moyen de commutation commandable par la deuxième horloge H2.

Dans le cas présent, la première capacité est en fait constituée de la charge capacitive commutée de la figure 4 c'est-à-dire des deux capacités C2 et C4 montées en parallèle, la capacité C4 étant commandable individuellement par le commutateur I4. La deuxième capacité est une charge capacitive commutée analogue à celle évoquée précédemment sur la figure 4 et composée ici de deux capacités C20 et C40 en parallèle, la capacité C40 étant commandable individuellement par un commutateur I40 analogue au commutateur 4.

Par ailleurs, les deux bornes de la deuxième capacité sont susceptibles d'être connectées à la masse par un quatrième moyen de commutation commandable par la première horloge.

Le premier moyen de commutation comprend ici un commutateur I8, tel qu'un transistor à effet de champ à grille isolée, connecté en série entre une première borne de la capacité C2 et la borne d'entrée BE ainsi qu'un autre commutateur I6 connecté en série entre la deuxième borne de la capacité C2 et la masse.

Le deuxième moyen de commutation comprend un commutateur I9 connecté en série entre la première borne de la capacité C2 et la masse et ayant une borne commune avec le commutateur I8, ainsi qu'un commutateur I7 connecté en série entre la borne de sortie BS1 et la deuxième borne de la capacité C2 et ayant une borne commune avec le commutateur I6.

Le troisième moyen de commutation comprend un commutateur I90 relié entre la borne d'entrée BE et une première borne de la capacité C20 ainsi qu'un commutateur I70 connecté en série entre la deuxième borne de la capacité C20 et l'autre borne de sortie BS2.

Le quatrième moyen de commutation comprend un commutateur I80 connecté en série entre la masse et la première borne de la capacité C20 et ayant une borne commune avec le commutateur I90, ainsi qu'un commutateur I60 connecté en série entre la masse et la deuxième borne de la capacité C20 et ayant une borne commune avec le commutateur I70.

D'une façon générale le fonctionnement de cet étage d'entrée est le suivant : lorsque les commutateurs I6 et I8 sont fermés, les commutateurs I7 et I9 étant ouverts, la capacité C2 (ou C2 + C4) se charge par la tension d'entrée. La capacité C20 (ou C20 + C40) quant à elle est déchargée puisque ses deux bornes sont reliées à la masse par l'intermédiaire des commutateurs I80 et I60. Puis, lorsque les commutateurs précédents, commandés par l'horloge H1, s'ouvrent et que les commutateurs I7, I9, I90 et I70 se ferment sous l'action de l'horloge H2, la tension d'entrée est appliquée d'une part à la borne de sortie BS2 par l'intermédiaire de la capacité C20 (ou C20 + C40) et, la tension présente en entrée lors de la charge de la capacité C2 est restituée à l'autre borne de sortie BS1. Les deux signaux de tension délivrés aux deux bornes BS1 et BS2 sont donc en fait légèrement décalés l'un par rapport à l'autre compte tenu du décalage des horloges H1 et H2.

Les capacités C3 et C30, permettant l'adjonction à la tension d'entrée échantillonnée des tensions de référence ±Vref, sont respectivement connectées aux bornes communes des commutateur I6, I7 et I60, I70. Les autres bornes respectives des deux capacités C3 et C30 sont reliées aux sources de tension de référence par des commutateurs I3 et I30, et à la masse par des commutateurs I5 et I50. Les deux bornes BS1 et BS2 sont respectivement reliées aux entrées inverseuses et non inverseuses de l'amplificateur opérationnel AO monté selon un montage différentiel et contre-réactionné par deux capacités de contre-réaction C1 et C10.

L'homme du métier saura déduire le fonctionnement global de ce codeur delta-sigma à partir de celui explicité pour la variante de réalisation de la figure 4, en ajustant si besoin le gain de l'amplificateur de tête par l'insertion des capacités C4 et C40. On remarquera ici que les charges capacitives commutées C2 et C4 d'une part, et C20 et C40 d'autre part, contribuent à la fois à la fonction de gain ajustable et à la fonction de production d'un signal différentiel permettant d'attaquer l'intégrateur du codeur. On réalise ainsi un gain de place supplémentaire. Par ailleurs, dans les codeurs à mise en forme de spectre de bruit, et en particulier des codeurs de type delta-sigma, la fréquence d'échantillonnage est très nettement supérieure à la fréquence du signal d'entrée. De ce fait, la distorsion induite par le léger décalage des signaux présents aux bornes BS1 et BS2 se situe en dehors de la bande passante du signal et n'influe donc pas sur le bon fonctionnement du codeur.

## Revendications

1. Codeur à mise en forme du spectre de bruit, en particulier de type delta-sigma, caractérisé par le fait qu'il comprend, en tête, un amplificateur à gain ajustable par capacités commutées (AO, C1, C2, C4).

2. Codeur selon la revendication 1, caractérisé par le fait qu'une partie au moins des éléments de l"amplificateur à gain ajustable forme également l'intégrateur à capacité commutée du codeur (AO, C1, C2).

3. Codeur selon la revendication 2, caractérisé par le fait qu'il comprend un amplificateur opérationnel (AO) entre la sortie et l'une des entrées duquel est connectée une capacité de contre-réaction (C1, C10), ainsi qu'une charge capacitive commutée (C2, C4, C20, C40), reliée à ladite entrée de l'amplificateur opérationnel (AO) et ajustable pour prendre des valeurs capacitives différentes.

4. Codeur selon la revendication 3, caractérisé par le fait que ladite charge capacitive comporte au moins une capacité commandable (C4) pour prendre un état passif et un état actif vis-à-vis de l'amplificateur opérationnel (AO).

5. Codeur selon l'une des revendications précédentes caractérisé par le fait qu'il comprend un étage d'entrée (1) à capacités commutées par deux horloges non recouvrantes (H1, H2), comportant une entrée (BE) pour un signal d'entrée et deux sorties (BS1, BS2) pour un signal de sortie différentiel, ces deux sorties étant reliées à l'intégrateur du codeur.

6. Codeur selon la revendication 5, caractérisé par le fait que l'étage d'entrée (1) comporte une première capacité (C2, C4) susceptible d'être connecté entre l'entrée et la masse par un premier moyen de commutation (I6, I8) commandable par la première horloge (H1), et entre la masse et l'une des sorties (BS1) par un deuxième moyen de commutation (I7, I9) commandable par la deuxième horloge (H2), ainsi qu'une deuxième capacité (C20, C40) susceptible d'être connectée entre l'entrée et l'autre sortie (BS2) par un troisième moyen (I70, I90) de commutation

commandable par la deuxième horloge (H2).

7. Codeur selon les revendications 3 et 6 prises en combinaison caractérisé par le fait que la première et la deuxième capacités sont respectivement constituées de deux charges capacitives (C2, C4; C20, C40) à valeurs ajustables.

8. Codeur selon la revendication 6 ou 7, caractérisé par le fait que les deux bornes de la deuxième capacité (C20, C40) sont susceptibles d'être connectées, à la masse par un quatrième moyen de commutation (I60, I80) commandable par la première horloge (H1).

# FIG.1

E(Z) → ⊗ [+/−] → B(Z) → [⎓] (Fe) → ⊕ [+/+] (N(Z)) → Y(Z)

C(Z)

# FIG.2

E(Z) → ⊗ [+/−] → [∫] → [⎓] (Fe) → Y(Z)

# FIG.3

B1 — H1 (M1) — C — H2 (M2) — B2

H1

H2

t    t+t1    t+te

6

FIG.4

FIG.5

EP 0 615 344 A1

**Office européen des brevets**

# RAPPORT DE RECHERCHE EUROPEENNE

Numero de la demande

EP 94 40 0522

## DOCUMENTS CONSIDERES COMME PERTINENTS

| Catégorie | Citation du document avec indication, en cas de besoin, des parties pertinentes | Revendication concernée | CLASSEMENT DE LA DEMANDE (Int.Cl.5) |
|---|---|---|---|
| A | PATENT ABSTRACTS OF JAPAN<br>vol. 014, no. 437 (E-980) 19 Septembre 1990<br>& JP-A-02 170 723 (YAMAHA)<br>* abrégé * | 1 | H03M3/02 |
| A | PATENT ABSTRACTS OF JAPAN<br>vol. 011, no. 306 (E-546) 6 Octobre 1987<br>& JP-A-62 098 918 (OKI ELECTRIC IND CO LTD)<br>* abrégé * | 1 | |
| D,A | EP-A-0 104 988 (P. SENN)<br>* abrégé * | 1 | |
| A | EP-A-0 072 741 (AMERICAN MICROSYSTEMS) | | |

DOMAINES TECHNIQUES RECHERCHES (Int.Cl.5)

H03M

Le présent rapport a été établi pour toutes les revendications

| Lieu de la recherche | Date d'achèvement de la recherche | Examinateur |
|---|---|---|
| LA HAYE | 15 Juin 1994 | Blaas, D-L |

CATEGORIE DES DOCUMENTS CITES

X : particulièrement pertinent à lui seul
Y : particulièrement pertinent en combinaison avec un autre document de la même catégorie
A : arrière-plan technologique
O : divulgation non-écrite
P : document intercalaire

T : théorie ou principe à la base de l'invention
E : document de brevet antérieur, mais publié à la date de dépôt ou après cette date
D : cité dans la demande
L : cité pour d'autres raisons

& : membre de la même famille, document correspondant

EPO FORM 1503 03.82 (P04C02)